# EUROPÄISCHE PATENTSCHRIFT

(11) **EP 4 103 386 B1**
(45) Veröffentlichungstag und Bekanntmachung des Hinweises auf die Patenterteilung: **20.11.2024**
(21) Anmeldenummer: 21703650.8
(22) Anmeldetag: 03.02.2021
(51) Int. Cl.: B29C 45/27, B29C 45/14, B29C 45/77, H01L 21/56, B29C 45/26, B29L 31/34

(54) **MOLD-VORRICHTUNG MIT SELBSTTÄTIG VERSTOPFENDEN EINSCHUSSKANAL**
MOULD DEVICE WITH AN AUTOMATICALLY PLUGGING FEED CHANNEL
DISPOSITIF DE MOULAGE DOTÉ D'UN CANAL D'ALIMENTATION À OBTURATION AUTOMATIQUE

(30) Priorität: 11.02.2020 DE 102020201666
(43) Veröffentlichungstag der Anmeldung: 21.12.2022
(73) Patentinhaber: Robert Bosch GmbH, 70442 Stuttgart (DE)
(72) Erfinder: FLEISCHMANN, Martin, 71083 Herrenberg (DE)
(86) Internationale Anmeldenummer: PCT/EP2021/052550
(87) Internationale Veröffentlichungsnummer: WO 2021/160490

(56) Entgegenhaltungen:
- EP-A1- 2 490 250
- DE-A1- 102014 100 281
- US-A1- 2014 206 122

## Beschreibung

### Stand der Technik

Die Erfindung betrifft eine Mold-Vorrichtung zum Erzeugen eines Mold-Moduls.

In der Offenlegungsschrift DE 10 2014 100 281 A1 ist offenbart, dass es aus der Praxis bekannt ist, Platinen und insbesondere die Bauteile auf den Platinen vor Beschädigungen zu schützen, indem separate miteinander verbundene und abgedichtete Schalen auf der Platine angeordnet werden. Darüber hinaus sind aus der Praxis Platinen bekannt, die im Niederdruckbereich mit unterschiedlichen Medien eingegossen oder verpackt sind. Bei einem Niederdruckbereich geht man von einem Bereich von circa 2 bis 40 bar aus. Ferner ist darauf hingewiesen, dass das Niederdruckeingießen den Nachteil aufweist, dass dieses Verfahren, wie auch das Schützen der Systeme durch separate Schalen, sehr zeitaufwendig und dadurch kostenintensiv
ist.

Aus der Offenlegungsschrift EP 2490250 A1 ist ein Moldmodul bekannt. Zur Herstellung des Moldmodules wird ein bestückter Schaltungsträger in den Hohlraum eines Spritzgusswerkzeuges eingelegt. Im Bereich eines Sensors wird ein Sperraufsatz auf den Schaltungsträger aufgelegt, so dass der Sensor von einem Ummolden durch eine Moldmasse freiliegend gehalten wird. Der restliche verbleibende Hohlraum wird mit der Moldmasse gefüllt, wodurch nach einem Aushärten das Moldmodul ausgebildet ist.

Die Offenlegungsschrift US 2014/0206122 A1 beschreibt ein Moldmodul umfassend einen Sensor, wobei im Bereich des Sensors im Mold eine Öffnung ausgebildet ist, welche bis zum Sensor reicht. Die Öffnung wird werkzeugseitig mit einem Pin innerhalb des Moldwerkzeuges ausgebildet. Dabei sitz der Pin auf dem Sensor auf und ermöglicht beim Einspritzen von Moldmasse in das Werkzeug lediglich das Umfließen der Moldmasse um den Pin herum.

### Offenbarung der Erfindung

Die Mold-Vorrichtung weist ein Werkzeugteil und ein weiteres Werkzeugteil auf. Das Werkzeugteil und das weitere Werkzeugteil umschließen gemeinsam einen Hohlraum. Von den Werkzeugteilen weist wenigstens ein Werkzeugteil, oder nur ein Werkzeugteil, wenigstens einen Trennsteg auf. Der Trennsteg ist angeordnet und ausgebildet, den Hohlraum in wenigstens zwei, oder nur zwei Teilräume, nämlich einen Niederdruckteilraum und einen Hochdruckteilraum, aufzuteilen. Das Werkzeugteil weist wenigstens zwei Einschusskanäle auf, von denen ein Niederdruckeinschusskanal in den Niederdruckteilraum mündet, und wenigstens auf einem Längsabschnitt einen kleineren Querschnitt aufweist, als ein in den Hochdruckteilraum mündender Hochdruckeinschusskanal. Der Niederdruckeinschusskanal ist ausgebildet, - insbesondere nach Ablauf oder während eines vorbestimmten Zeitintervalls, - durch Erhärten der Mold-Masse druckfest zu verstopfen. Der Hochdruckeinschusskanal ist ausgebildet, währenddessen einen Mold-Druck für eine längere Zeit, insbesondere ein längeres Zeitintervall, in den Hohlraum zu leiten, als der Niederdruckeinschusskanal. Vorteilhaft kann so die Mold-Masse in dem Hochdruckeinschusskanal noch flüssig, insbesondere zähflüssig, bleiben und so den Mold-Druck weiter auf den Hochdruckteilraum, und die so in dem Hochdruckteilraum eingefüllte Mold-Masse, einwirken lassen. Die in den Niederdruckteilraum gefüllte Mold-Masse kann den Mold-Druck, welcher bevorzugt von einer gemeinsamen Pressvorrichtung erzeugt wird, welche ausgebildet ist, den Mold-Druck sowohl auf den Niederdruckeinschusskanal, als auch auf den Hochdruckeinschusskanal wirken zu lassen, nicht mehr empfangen, nachdem der Niederdruckeinschusskanal durch erhärtete Mold-Masse verstopft worden ist. Vorteilhaft kann so in demselben Werkzeug, umfassend die Werkzeugteile, während eines Mold-Prozesses zueinander verschiedene Mold-Körper erzeugt werden, welche mit jeweils zueinander verschiedenen Prozessdrücken, zuvor auch Mold-Druck genannt, erzeugt worden sind.

In einer bevorzugten Ausführungsform weist der Niederdruckeinschusskanal einen - insbesondere im Vergleich zu dem benachbarten Kanalabschnitt - verengten Längsabschnitt auf, dessen Querschnittsdurchmesser oder Querschnittsfläche weniger als die Hälfte des Querschnittsdurchmessers oder der Querschnittsfläche des Hochdruckeinschusskanals beträgt. Vorteilhaft kann die Mold-Masse so in dem verengten Längsabschnitt des Niederdruckeinschusskanals nach einer vorbestimmten Verweilzeit erstarren, und so den verengten Längsabschnitt sicher verstopfen. Der Mold-Druck, welcher von der Pressvorrichtung daraufhin erhöht werden kann, kann so nur noch über die noch zähflüssige Mold-Masse in dem Hochdruckeinschusskanal, dessen Querschnittsdurchmesser hinreichend groß ausgebildet ist, sodass die Mold-Masse dort nicht erstarren kann, auf den Hochdruckteilraum wirken.

In einer bevorzugten Ausführungsform ist der Trennsteg ausgebildet und angeordnet, auf einen von den Werkzeugteilen eingeschlossenen Schaltungsträger insbesondere federnd aufzusetzen, und den so zwischen dem Schaltungsträger und dem Werkzeugteil gebildeten Hohlraum in den Niederdruckhohlraum und den Hochdruckhohlraum aufzuteilen. Vorteilhaft können so auf einem Schaltungsträger zwei zueinander verschiedene Mold-Körper oder Mold-Höcker erzeugt werden, welche jeweils mit zueinander verschiedenen Prozessdrücken erzeugt worden sind. Vorteilhaft kann so in einen Mold-Körper, welcher in dem Niederdruckteilraum erzeugt worden ist, druckempfindliche Bauelemente, beispielsweise ein Elektrolytkondensator, ein Sensor oder ein Schwingquarz, in die Mold-Masse eingebettet sein. Vorteilhaft kann der Elektrolytkondensator, der Sensor oder der Schwingquarz so nicht durch einen zu hohen Mold-Druck, beispielsweise mehr als 20 Bar, zerstört werden. In dem Hochdruckteilraum können so vorteilhaft elektronische Bauelemente in Mold-Masse eingebettet werden, welche auf dem Schaltungsträger in einem Flächenbereich angeordnet sind, der an den Hochdruckteilraum angrenzt. Die in dem Hochdruckteilraum angeordneten Bauelemente können so mit einem Mold-Druck zwischen 50 und 200 Bar, bevorzugt zwischen 80 und 150 Bar, weiter bevorzugt 100 Bar in Mold-Masse eingebettet werden. Vorteilhaft können so bei einem solch hohen Mold-Druck gute Unterfüll-Eigenschaften erreicht werden, sodass die Mold-Masse auch in feine Spalte zwischen einem elektronischen Bauelement, beispielsweise einem integrierten Schaltkreis, und dem Schaltungsträger fließen kann.

In einer bevorzugten Ausführungsform weist das Werkzeugteil eine mit dem Werkzeugteil verbundene, oder an das Werkzeugteil angeformte Pressvorrichtung auf. Die Pressvorrichtung ist ausgebildet, insbesondere zähflüssige Mold-Masse in die Einschusskanäle zu pressen. Vorteilhaft können so mit nur einem Mold-Werkzeug, und in einem Mold-Prozessschritt, zueinander verschiedene Mold-Körper mit jeweils zueinander verschiedenen Prozessdrücken erzeugt werden.

In einer bevorzugten Ausführungsform weist die Mold-Vorrichtung einen Drucksensor auf. Der Drucksensor ist ausgebildet, einen Mold-Druck, insbesondere einen Prozessdruck, in dem Niederdruckeinschusskanal zu erfassen. Bevorzugt ist der Drucksensor im Bereich des Niederdruckhohlraums angeordnet. Vorteilhaft kann die Mold-Vorrichtung so vor einem Erhöhen des Mold-Drucks, beginnend von 20 Bar bis hin zu 200 Bar, den Mold-Druck im Bereich des Niederdruckteilraums erfassen, und so sicherstellen, dass der Niederdruckeinschusskanal von einer dort erhärteten Mold-Masse dicht verschlossen ist. Die Mold-Vorrichtung weist dazu bevorzugt eine Verarbeitungseinheit, insbesondere einen Mikroprozessor oder einen Mikrocontroller auf, wobei die Verarbeitungseinheit ausgebildet ist, ein von dem Drucksensor erzeugtes Drucksignal zu empfangen, und in Abhängigkeit des Drucksignals einen Mold-Druck zu steigern.

In einer bevorzugten Ausführungsform weist die Mold-Vorrichtung eine Massenflusserfassungsvorrichtung auf, welche ausgebildet ist, einen in dem Niederdruckeinschusskanal fließenden Mold-Massenfluss zu erfassen, und ein den Mold-Massenfluss repräsentierendes Mold-Massenflusssignal zu erzeugen. Die Mold-Vorrichtung ist weiter bevorzugt ausgebildet, den Mold-Druck oder das Mold-Masseneinschussvolumen in Abhängigkeit des Mold-Massenflusssignals zu steuern. Vorteilhaft kann so der Mold-Massenfluss während des Mold-Prozesses von der Mold-Vorrichtung erfasst werden, sodass mittels des Mold-Massenflusssignals ein Verstopfen des Niederdruckeinschusskanals sicher erfasst werden kann.

Die Mold-Massenflusserfassungsvorrichtung weist beispielsweise einen Dielektrizitäts-Sensor auf, welcher ausgebildet ist, eine dielektrische Eigenschaft der Mold-Masse - bevorzugt kapazitiv zu erfassen, und ein Bewegen, insbesondere Fließen der Mold-Masse kapazitiv zu erfassen. Der Mold-Massenflusssensor ist ausgebildet, in Abhängigkeit der erfassten fließenden Mold-Masse ein die Kapazitätsänderung, oder die Kapazität im Bereich des Niederdruckeinschusskanals, repräsentierendes Mold-Massenflusssignal zu erzeugen. Vorteilhaft kann so ein Verstopfen des Niederdruck-Einschusskanals sensorisch erfasst werden, um so in Abhängigkeit des Sensorsignals des Moldmassenflusssensors den Molddruck weiter über den für den Niederdruck-Teilraum vorbestimmten Höchstdruckwert, insbesondere 20 Bar, hinaus zu steigern.

In einer bevorzugten Ausführungsform ist die Mold-Vorrichtung ausgebildet, den Mold-Druck nach Ablauf des vorbestimmten Zeitintervalls zu erhöhen. Die Mold-Vorrichtung ist bevorzugt ausgebildet, den Mold-Druck nach einem Einfüllen der Mold-Masse in die Teilräume bis hin zu einem Mold-Druck von 20 Bar zu erhöhen, und nach Ablauf des vorbestimmten Zeitintervalls, weiter bevorzugt in Abhängigkeit des Drucksignals und/oder des Massenflusssignals, den Mold-Druck weiter bis hin zu 100 Bar zu erhöhen. Vorteilhaft kann so mit dem nur einen Mold-Werkzeug ein Mold-Modul mit jeweils zueinander verschiedenen Prozessdrücken erzeugten Mold-Körpern erzeugt werden.

Die Erfindung betrifft auch ein Mold-Modul, insbesondere erzeugt mittels einer Mold-Vorrichtung gemäß der vorbeschriebenen Art. Das Mold-Modul weist wenigstens ein druckempfindliches Bauelement, insbesondere einen Elektrolytkondensator, einen Schwingquarz oder einen Sensor auf, wobei das druckempfindliche Bauelement in einen Mold-Körper oder einen Mold-Höcker eingebettet ist, der mit einem Mold-Druck von kleiner oder gleich 20 Bar erzeugt worden ist. Bevorzugt weist das Mold-Modul einen Schaltungsträger auf, wobei der Mold-Körper an den Schaltungsträger angeformt ist, oder der Schaltungsträger in den Mold-Höcker eingebettet ist. Der Mold-Körper mit dem druckempfindlichen Bauelement kann beispielsweise in dem Niederdruckteilraum der bereits beschriebenen Mold-Vorrichtung erzeugt sein. Vorteilhaft kann so das druckempfindliche Bauelement unbeschädigt in dem mittels eines Kunststoffdruckgussverfahrens, beispielsweise mittels Transfer-Molden oder mittels Direct-Injection-Molding, erzeugten Mold-Körper eingebettet sein. Insofern weist das Moldmodul zwei zueinander verschiedene Moldkörper auf, nämlich einen Hochdruck-Moldkörper und einen Niederdruck-Moldkörper, wobei druckunempfindliche Bauelemente jeweils in dem Hochdruck-Moldkörper eingebettet sind und die druckempfindlichen Bauelemente jeweils in dem Niederdruck-Moldkörper eingebettet sind, wobei der Niederdruck-Moldkörper mit dem kleineren Prozessdruck erzeugt ist als der Hochdruck-Moldkörper.

Die Erfindung betrifft auch ein Verfahren zum Erzeugen eines Mold-Moduls mittels eines Kunststoffdruckgussverfahrens, beispielsweise mittels Transfer-Molden oder mittels Direct-Injection-Molding. Bei dem Verfahren wird in einem Verfahrensschritt ein Schaltungsträger mit elektronischen Bauelementen in einen Hohlraum eines Mold-Werkzeugs eingebracht. Der Hohlraum ist bevorzugt von dem Mold-Werkzeug in einen Niederdruckteilraum und einen Hochdruckteilraum aufgeteilt. In einem weiteren Verfahrensschritt wird der Niederdruckteilraum über einen in dem Mold-Werkzeug ausgebildeten, und in den Niederdruckteilraum mündenden Niederdruckeinschusskanal mit Mold-Masse gefüllt. Der Hochdruckteilraum wird über einen in dem Mold-Werkzeug ausgebildeten, und in den Hochdruckteilraum mündenden Hochdruckeinschusskanal mit Mold-Masse gefüllt.

Bevorzugt wird bei dem Verfahren der Mold-Druck, insbesondere ein auf die in den Teilräumen eingefüllte Mold-Masse über die Einschusskanäle wirkender Prozessdruck, bis zu einem vorbestimmten Niederdruckwert, insbesondere 20 Bar, erhöht. Weiter bevorzugt wird nach einem vorbestimmten Zeitintervall, insbesondere nach einem Verstopfen des Niederdruckeinschusskanals, der Mold-Druck bis zu einem Hochdruckwert, insbesondere 100 Bar, weiter erhöht. Vorteilhaft kann so durch das Verstopfen des Niederdruckeinschusskanals der Mold-Druck nicht mehr auf den Niederdruckteilraum wirken. Vorteilhaft können so in dem Niederdruckteilraum eingeschlossene druckempfindliche Bauelemente, insbesondere ein Elektrolytkondensator, oder ein Schwingquarz, oder ein Sensor, nicht durch den weiter gesteigerten Mold-Druck beschädigt oder zerstört werden.

Bevorzugt sind mit dem Schaltungsträger elektronische Bauelemente, insbesondere wenigstens ein, oder mehrere Niederdruckbauelemente verlötet. Weiter bevorzugt sind mit dem Schaltungsträger druckunempfindliche Bauelemente, insbesondere ein integrierter Schaltkreis, ein Widerstand, ein Folienkondensator, oder wenigstens ein Halbleiterbauelement, beispielsweise eine Diode, oder ein anderes Halbleiterbauelement verlötet. Die druckunempfindlichen Bauelemente sind bevorzugt in einen Mold-Körper eingebettet, welcher in dem Hochdruckteilraum erzeugt worden ist. Vorteilhaft kann so ein Mold-Modul gebildet sein, welches zwei mit zueinander verschiedenen Prozessdrücken erzeugte Mold-Körper, oder Mold-Höcker aufweist. Die Mold-Körper, oder Mold-Höcker sind beispielsweise auf einem Schaltungsträger ausgebildet, und umschließen die auf dem Schaltungsträger angeordneten elektronischen Bauelemente, welche in den jeweiligen Mold-Höcker hineinragen.

Die Erfindung wird nun im Folgenden anhand von Figuren und weiteren Ausführungsbeispielen beschrieben. Weitere vorteilhafte Ausführungsvarianten ergeben sich aus einer Kombination der in den Figuren und in den abhängigen Ansprüchen beschriebenen Merkmale.
Figur 1 zeigt ein Ausführungsbeispiel für eine Mold-Vorrichtung, welche ausgebildet ist, ein Moldmodul mit zwei zueinander verschiedenen Moldkörpern zu erzeugen, die jeweils mit zueinander verschiedenen Drücken erzeugt werden können;
Figur 2 zeigt die in Figur 1 bereits dargestellte Moldvorrichtung in einer Aufsicht;
Figur 3 zeigt ein mit der in den Figuren 1 und 2 dargestellten Moldvorrichtung erzeugtes Moldmodul, bei dem druckempfindliche Bauelemente und druckunempfindliche Bauelemente jeweils in zueinander verschiedene Moldkörper eingebettet sind.
ein Ausführungsbeispiel für

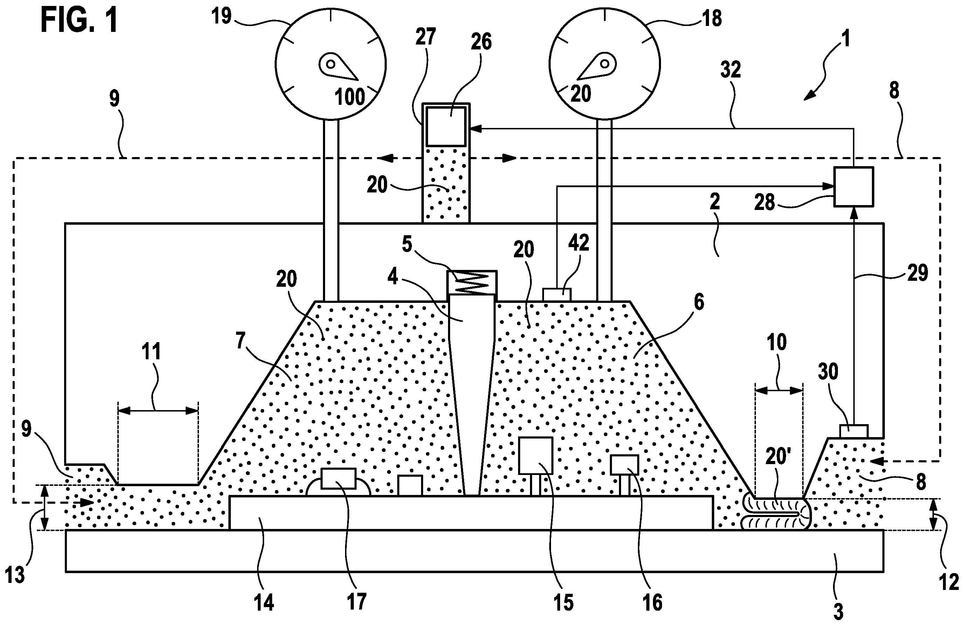

Figur 1 zeigt - schematisch - ein Ausführungsbeispiel für eine Mold-Vorrichtung 1. Die Mold-Vorrichtung 1 weist ein Werkzeugteil 2, und ein weiteres Werkzeugteil 3 auf, welche gemeinsam einen Hohlraum umschließen. Der Hohlraum ist in diesem Ausführungsbeispiel mittels einer mit dem Werkzeugteil 3 über eine Feder 5 federnd verbundene Trennwand 4, zuvor auch Trennsteg genannt, in zwei Teilräume aufgeteilt, nämlich in einen Niederdruckteilraum 6, und einen Hochdruckteilraum 7. In das so gebildete, zweischalige Werkzeug, ist in diesem Ausführungsbeispiel ein Schaltungsträger 14 eingebracht, welcher von der Mold-Vorrichtung 1 mit Mold-Masse 20 umhüllt werden kann. Der Schaltungsträger umfasst in diesem Ausführungsbeispiel auch mit dem Schaltungsträger 14 verbundene elektronische Bauelemente, nämlich Niederdruckbauelemente 15 und 16, insbesondere einen Elektrolytkondensator, einen Sensor oder einen Schwingquarz. Beispielsweise der Elektrolytkondensator 15 und der Schwingquarz 16 ragen in diesem Ausführungsbeispiel in den Niederdruckteilraum 6 hinein. Der Schaltungsträger 14 liegt in diesem Ausführungsbeispiel auf dem Werkzeugteil 3 auf. Mit dem Schaltungsträger 14 sind auch weitere elektronische Bauelemente, insbesondere ein integrierter Schaltkreis 17, verbunden. Die weiteren Bauelemente, insbesondere der Schaltkreis 17, ragen in diesem Ausführungsbeispiel in den Hochdruckteilraum 7 hinein. Die weiteren Bauelemente sind weniger druckempfindlich, sodass sie beim Molden einem höheren Mold-Druck standhalten.

Der Niederdruckteilraum 6 ist in diesem Ausführungsbeispiel mit einem Niederdruck-Einschusskanal 8 verbunden. Der Niederdruckeinschusskanal 8 weist auf einem Längsabschnitt 10 eine Querschnittsfläche 12 auf. Der Hochdruckteilraum 7 ist mit einem Hochdruck-Einschusskanal 9 verbunden, der auf einem Längsabschnitt 11 eine Querschnittsfläche 13 aufweist. Die Querschnittsfläche 12 des Niederdruck-Einschusskanals 8 ist kleiner ausgebildet als die Querschnittsfläche 13 des Hochdruck-Einschusskanals 9.

Zu einem Erzeugen eines Mold-Moduls kann der Schaltungsträger 14, mit dem die elektronischen Bauelemente 15, 16 und 17 verlötet sind, in das Werkzeug, umfassend die Werkzeugteile 2 und 3, eingelegt werden und von den Werkzeugteilen 2 und 3 umschlossen werden. Die mittels der Feder 5 federnd gelagerte Trennwand 4 kann dabei auf den Schaltungsträger 14 aufsetzen, sodass der Niederdruckhohlraum 6 an den Schaltungsträger 14, und so auch an die Niederdruckbauelemente 15 und 16 angrenzt, jedoch durch die Trennwand 4 von dem Hochdruckteilraum 7 getrennt ist. Die Mold-Masse 20 kann dann sowohl durch die Einschussöffnung 8, als auch durch die Einschussöffnung 9 in das Mold-Werkzeug eingeschossen werden. Dabei kann die Mold-Masse durch den Einschusskanal 8, welcher in den Niederdruckteilraum 6 mündet, in den Niederdruckteilraum 6 einfließen. Der Hochdruckteilraum 7 kann über den Einschusskanal 9, welcher in den Hochdruckteilraum 7 mündet, mit Mold-Masse gefüllt werden. Nach dem Füllen des Mold-Werkzeugs mit Mold-Masse 20 kann dann der Mold-Druck bis auf 20 Bar gesteigert werden, und dort für ein vorbestimmtes Zeitintervall gehalten werden. Während dieses Zeitintervalls kann die Mold-Masse 20 auf dem Längsabschnitt 10 des Einschusskanals 8, welcher auf dem Längsabschnitt 10 schmaler ausgebildet ist, als der Einschusskanal 9 für den Hochdruckteilraum 7, auf dem Längsabschnitt 11, zu einer verfestigten Mold-Masse 20' verklumpen oder erstarren. Der Niederdruckteilraum 6 ist so nicht mehr für einen Mold-Druck, welcher über den Einschusskanal 8 auf den Niederdruckteilraum 6 wirken kann, zugänglich.

Der Mold-Druck kann dann von einer - in Figur 1 nicht dargestellten - Pressvorrichtung, umfassend einen Presskolben, weiter gesteigert werden, in diesem Beispiel bis zu 100 Bar. Figur 1 zeigt auch eine Druckerfassungsvorrichtung 18, welche mit dem Niederdruckteilraum 6 wirkverbunden ist, und eine Druckerfassungsvorrichtung 19, welche mit dem Hochdruckteilraum 7 wirkverbunden ist. Die Druckerfassungsvorrichtung 18 zeigt in diesem Ausführungsbeispiel einen Mold-Druck von 20 Bar, welcher maximal auf den Niederdruckteilraum 6 wirken kann, insoweit der Einschusskanal 8 durch die diesen verstopfende erstarrte Mold-Masse 20' verschlossen ist. Die Mold-Vorrichtung 1 umfasst in diesem Ausführungsbeispiel auch eine Pressvorrichtung 27, welche an das Werkzeugteil 2 angeformt sein kann. Die Pressvorrichtung 27 umfasst einen Presskolben 26, welcher ausgebildet ist, eine zähflüssige Mold-Masse 20 über die Einschusskanäle 8 und 9 in die Teilräume, insbesondere den Niederdruckteilraum 6, beziehungsweise den Hochdruckteilraum 7 zu pressen.

Die Mold-Vorrichtung 1 umfasst in diesem Ausführungsbeispiel auch einen Mold-Massenflusssensor 300. Der Mold-Massenflusssensor 300 ist ausgebildet, einen Mold-Massenfluss in dem Einschusskanal 8, insbesondere im Bereich des Niederdruckteilraums 6, zu erfassen und ein den Mold-Massenfluss repräsentierendes Masseflusssignal zu erzeugen, und dieses ausgangsseitig über eine Verbindungsleitung an eine Verarbeitungseinheit 28 auszugeben. Die Moldvorrichtung 1 weist auch einen Drucksensor 42 auf, welcher angeordnet und ausgebildet ist, den Druck in dem Niederdruckteilraum 6 zu erfassen und ein den Druck repräsentierendes Drucksignal zu erzeugen und an die Verarbeitungseinheit 28 zu senden.

Die Moldvorrichtung 1 umfasst auch die Verarbeitungseinheit 28, welche ausgebildet ist, in Abhängigkeit des eingangsseitig empfangenen Mold-Flusssignals und/oder in Abhängigkeit des Drucksignals ein Steuersignal über eine Verbindungsleitung 32 an die Pressvorrichtung 27 zu senden. Die Pressvorrichtung 27 ist ausgebildet, in Abhängigkeit des empfangenen Steuersignals den Mold-Druck zu steigern, insbesondere beginnend von 20 Bar an, auf bis zu 100 Bar zu steigern.

Vorteilhaft kann so in Abhängigkeit des erfassten Stillstands der Mold-Masse 20 in dem Einschusskanal 8 die Pressvorrichtung 27 angewiesen werden, den Mold-Massendruck bis auf 100 Bar zu steigern. Vorteilhaft kann so sichergestellt werden, dass die Niederdruckbauelemente 15 und 16, insbesondere ein Elektrolytkondensator, oder ein Schwingquarz, bei dem bis auf 100 Bar ansteigenden Mold-Massendruck nicht zerstört werden können.

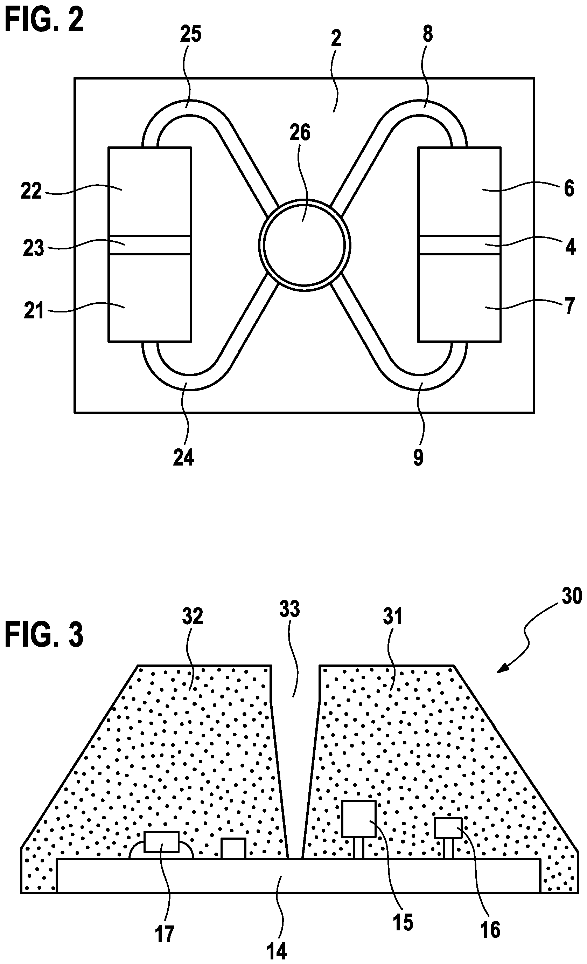

Figur 2 zeigt die in Figur 1 bereits gezeigte Mold-Vorrichtung 1, insbesondere in einer Aufsicht auf das Werkzeugteil 2. Das Werkzeugteil 2 umfasst in diesem Ausführungsbeispiel den in Figur 1 bereits dargestellten Presskolben 26, welcher ausgebildet ist, eine Mold-Tablette, insbesondere in erweichter Form, als erweichte Mold-Masse durch die Einschusskanäle 8 und 9 zu pressen, und über die Einschusskanäle 8 und 9 in den Niederdruckteilraum 6 beziehungsweise den Niederdruckteilraum 7 zu drücken. Die Einschusskanäle 8 und 9 sind in diesem Ausführungsbeispiel in dem Werkzeugteil 2 als sich jeweils längs erstreckende Hohlräume ausgebildet. Figur 2 zeigt auch mit dem Presskolben 26 wirkverbundene Einschusskanäle 24 und 25, welche zu zwei - zu den Teilräumen 6 und 7 - insbesondere zueinander punktsymmetrisch - angeordneten Teilhohlräumen, nämlich einem Niederdruckteilraum 21, und einem Hochdruckteilraum 22, hinführen. Der Einschusskanal 24 ist als Niederdruckeinschusskanal ausgebildet, welcher wie der in Figur 1 bereits dargestellte Niederdruckeinschusskanal 8 einen Engpass aufweist, welcher ausgebildet ist, Mold-Masse beim Verweilen in dem Engpass zum Erstarren zu bringen.

Figur 3 zeigt ein Ausführungsbeispiel für ein Mold-Modul 30. Das Mold-Modul 30 ist beispielsweise mittels der in Figur 1 dargestellten Mold-Vorrichtung 1 erzeugt. Das Mold-Modul 30 weist einen als Mold-Höcker ausgebildeten Mold-Körper 31 auf, in welchen die Niederdruckbauelemente 15 und 16 eingebettet sind. Das Mold-Modul 30 weist auch einen Mold-Körper 32 auf, in welchen die Hochdruckbauelemente, insbesondere der integrierte Schaltkreis 17, eingebettet sind. Die Mold-Körper 31 und 32 sind durch einen Graben 33 voneinander getrennt, welcher sich bis hin zu dem Schaltungsträger 14 erstreckt. Der Schaltungsträger 14 ist Bestandteil des Mold-Moduls 30. Insofern weist das Moldmodul zwei zueinander verschiedene Moldkörper 31, 32 auf, nämlich einen Hochdruck-Moldkörper 32 und einen Niederdruck-Moldkörper 31, wobei die druckunempfindliche Bauelemente 17 jeweils in dem Hochdruck-Moldkörper 32 eingebettet sind und die druckempfindlichen Bauelemente 15, 16 jeweils in dem Niederdruck-Moldkörper 31 eingebettet sind, wobei der Niederdruck-Moldkörper 31 mit dem kleineren Prozessdruck erzeugt ist als der Hochdruck-Moldkörper 32.

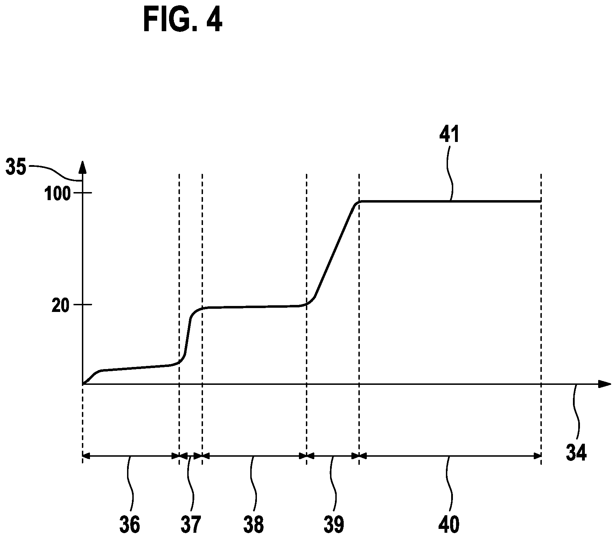

Figur 4 zeigt ein Ausführungsbeispiel für ein Diagramm, welches eine Abszisse 34, und eine Ordinate 35 aufweist. Die Abszisse 34 repräsentiert in diesem Ausführungsbeispiel eine Zeitachse, wobei die Ordinate 35 eine Druckachse eines beim Molden mittels des in Figur 1 dargestellten Mold-Werkzeugs 1 auf die Teilräume 6 und 7 wirkenden Mold-Drucks repräsentiert.

Figur 4 zeigt auch eine Druckkurve 41, welche einen zeitlichen Druckverlauf eines Mold-Druckes zum Erzeugen eines Mold-Moduls mittels der in Figur 1 dargestellten Mold-Vorrichtung 1 repräsentiert. Während eines Zeitintervalls 36 kann in einem ersten Schritt zum Erzeugen eines Mold-Moduls mittels eines ansteigenden Mold-Druckes der Niederdruckteilraum 6 durch den Einschusskanal 8, und der Hochdruckteilraum 7 über den Einschusskanal 9 mit Mold-Masse 20 gefüllt werden.

Während eines daran anschließenden Zeitintervalls 37 kann ein Mold-Druck weiter aufgebaut werden, bis hin zu einem vorbestimmten Druckwert, beispielsweise 20 Bar, welcher einen Höchstdruck für den Niederdruckteilraum 6 bildet.

Beim Erreichen des vorbestimmten Druckwertes, in diesem Ausführungsbeispiel 20 Bar, wird der Druck während des Zeitintervalls 38 bei dem vorbestimmten Druckwert aufrechterhalten. Während eines an das Zeitintervall 38, und so nach dem Druckaufbau anschließenden Zeitintervalls 38, kann der vorbestimmte Mold-Druck für beide Teilräume, nämlich den Niederdruckteilraum 6 und den Hochdruckteilraum 7, von der Mold-Pressvorrichtung aufrechterhalten werden. Die Moldmasse 20 kann in dem Einschusskanal auf dem Längsabschnitt 10 erstarren und eine den Niederdruckteilraum verschließende erstarrte Moldmasse 20' ausbilden. Während eines an das Zeitintervall 38 anschließenden Zeitintervalls 39 kann der Mold-Druck weiter gesteigert werden, bis zum Erreichen eines Enddruckes für den Hochdruckteilraum 7. Der Wert für den Enddruck des Mold-Druckes für den Hochdruckteilraum 7 beträgt in diesem Ausführungsbeispiel 100 Bar.

Die Druckkurve 41 weist somit fünf verschiedene Verlaufsabschnitte auf. Ein Füllabschnitt, während dem die Teilräume der Mold-Vorrichtung mit Mold-Masse gefüllt werden, erstreckt sich während des Zeitintervalls 36. Ein daran anschließender Druckaufbauabschnitt erstreckt sich während des Zeitintervalls 37, ein Druckhalteabschnitt mit begrenztem Druckwert, insbesondere 20 Bar für den Niederdruckteilraum, erstreckt sich während des Zeitintervalls 38, ein weiterer Druckaufbauabschnitt zum Beaufschlagen des Hochdruckes für den Hochdruckteilraum 7 erstreckt sich während des Zeitintervalls 39, und ein Enddruckabschnitt zum Halten eines Enddruckes für den Hochdruckteilraum 7 erstreckt sich während des Zeitintervalls 40.

## Patentansprüche

1. Moldvorrichtung (1) zum Erzeugen eines Moldmoduls (30),
wobei die Moldvorrichtung (1) ein Werkzeugteil (2) und ein weiteres Werkzeugteil (3) aufweist, die gemeinsam einen Hohlraum (6, 7) umschließen,
und ein Werkzeugteil (2) wenigstens eine Trennwand (4) aufweist, welche angeordnet und ausgebildet ist, den Hohlraum (6, 7, 21, 22) in wenigstens zwei oder nur zwei Teilräume (6, 7), nämlich einen Niederdruck-Teilraum (6, 21) und einen Hochdruck-Teilraum (7, 22) aufzuteilen, und das Werkzeugteil (2) wenigstens zwei Einschusskanäle (8, 9, 24, 25) aufweist, und von denen ein Niederdruck-Einschusskanal (8) in den Niederdruck-Hohlraum (6) mündet und wenigstens auf einem Längsabschnitt (10) einen kleineren Querschnitt (12) aufweist als ein in den Hochdruck-Teilraum (7) mündender Hochdruck-Einschusskanal (9), und wobei der Niederdruck-Einschusskanal (8) ausgebildet ist, insbesondere während eines vorbestimmten Zeitintervalls (38), durch erhärtende Moldmasse (20') druckfest zu verstopfen, während der Hochdruck-Einschusskanal (9) ausgebildet ist, einen Molddruck (19) für ein längeres Zeitintervall (40) in den Hohlraum (7) zu leiten als der Niederdruck-Einschusskanal (8).

2. Moldvorrichtung (1) nach Anspruch 1,
**dadurch gekennzeichnet, dass**
der Niederdruck-Einschusskanal (8) einen insbesondere im Vergleich zu dem benachbarten Kanalabschnitt verengten Längsabschnitt (10) aufweist, dessen Querschnittsdurchmesser (12) weniger als die Hälfte des Querschnittsdurchmessers (13) des Hochdruck-Einschusskanals (9) oder dessen Querschnittsfläche weniger als die Hälfte der Querschnittsfläche des Hochdruck-Einschusskanals (9) beträgt.

3. Moldvorrichtung (1) nach Anspruch 1 oder 2,
**dadurch gekennzeichnet, dass**
die Trennwand (4) ausgebildet und angeordnet ist, auf einen von den Werkzeugteilen (2, 3) eingeschlossenen Schaltungsträger (14) insbesondere federnd aufzusetzen und den so zwischen dem Schaltungsträger (14) und dem Werkzeugteil (2) gebildeten Hohlraum (6, 7) in den Niederdruck-Hohlraum (6) und den Hochdruck-Hohlraum (7) aufzuteilen.

4. Moldvorrichtung (1) nach einem der vorhergehenden Ansprüche,
**dadurch gekennzeichnet, dass**
das Werkzeugteil (2) eine mit dem Werkzeugteil (2) verbundene oder an das Werkzeugteil (2) angeformte Pressvorrichtung (27) aufweist, welche ausgebildet ist, insbesondere zähflüssige Moldmasse (20) in die Einschusskanäle (8,9) zu pressen.

5. Moldvorrichtung (1) nach einem der vorhergehenden Ansprüche,
**dadurch gekennzeichnet, dass**
die Moldvorrichtung (1) einen Drucksensor (42) aufweist, welcher ausgebildet ist einen Molddruck in dem Niederdruck-Einschusskanal (8) zu erfassen.

6. Moldvorrichtung (1) nach Anspruch 5,
**dadurch gekennzeichnet, dass**
der Drucksensor (42) im Bereich des Niederdruck-Hohlraums (6) angeordnet ist.

7. Moldvorrichtung (1) nach einem der vorhergehenden Ansprüche,
**dadurch gekennzeichnet, dass**
die Moldvorrichtung (1) eine Massenflusserfassungsvorrichtung (300) aufweist, welche ausgebildet ist, einen in dem Niederdruck-Einschusskanal (8) fließenden Moldmassenfluss zu erfassen, und ein den Moldmassenfluss repräsentierendes Moldmassenflusssignal zu erzeugen und die Moldvorrichtung (1) ausgebildet ist, den Molddruck oder das Moldmassen-Einschussvolumen in Abhängigkeit des Moldmassenflusssignals zu steuern.

8. Moldvorrichtung (1) nach einem der vorhergehenden Ansprüche,
**dadurch gekennzeichnet, dass**
die Moldvorrichtung (1) ausgebildet ist, den Molddruck nach Ablauf des vorbestimmten Zeitintervalls (38) zu erhöhen.

9. Moldmodul (30), umfassend einen Schaltungsträger (14), fürs Ummolden mit einem Molddruck von 50 bis 200 bar druckunempfindliche Bauelemente (17) und wenigstens ein fürs Ummolden mit einen Molddruck ab 50 bar druckempfindliches Bauelement (15, 16), insbesondere Elektrolytkondensator, Schwingquarz oder Sensor, und insbesondere erzeugt mittels einer Moldvorrichtung (1) nach einem der vorhergehenden Ansprüche,
**dadurch gekennzeichnet, dass**
das Moldmodul (30) zwei zueinander verschiedene Moldkörper (31, 32) aufweist, nämlich einen Hochdruck-Moldkörper (32) und einen Niederdruck-Moldkörper (31), wobei druckunempfindliche Bauelemente (17) jeweils in dem Hochdruck-Moldkörper (32) eingebettet sind und die druckempfindlichen Bauelemente (15, 16) jeweils in dem Niederdruck-Moldkörper (31) eingebettet sind, wobei der Niederdruck-Moldkörper (31) mit dem kleineren Prozessdruck erzeugt ist, nämlich mit einem Molddruck von kleiner oder gleich 20 Bar, als der Hochdruck-Moldkörper (32), welcher mit einem Molddruck zwischen 50 und 200 bar erzeugt ist.

10. Verfahren zum Erzeugen eines Moldmoduls (30) mittels eines Kunststoffdruckgussverfahrens, beispielsweise mittels Transfer-Molden oder mittels Direct-Injection-Molding,
wobei ein Schaltungsträger (14) mit elektronischen Bauelementen (14, 15, 16, 17) einen Hohlraum (6, 7) eines Moldwerkzeugs (2, 3) einer Moldvorrichtung (1) eingebracht wird und der Hohlraum (6, 7) von dem Moldwerkzeug (2, 3) mittels einer mit diesem verbundenen Trennwand (4), in einen Niederdruckteilraum (6) und einen Hochdruckteilraum (7) aufgeteilt ist,
und der Niederdruck-Teilraum (6) über einen in dem Moldwerkzeug (2, 3) ausgebildeten und in den Niederdruck-Teilraum (6) mündenden Niederdruck-Einschusskanal (8) mit Moldmasse (20) gefüllt wird,
und der Hockdruck-Teilraum (7) wird über einen in dem Moldwerkzeug (2, 3) ausgebildeten und in den Hockdruck-Teilraum (7) mündenden Hochdruck-Einschusskanal (9) mit Moldmasse 20 gefüllt wird,
und der Molddruck bis zu einem vorbestimmten Niederdruckwert, insbesondere 20 Bar, erhöht wird, und nach einem vorbestimmten Zeitintervall (38) bis zu einem Verstopfen des Niederdruck-Einschusskanals (8), der Molddruck bis zu einem Hochdruckwert, insbesondere 100 Bar, weiter erhöht wird.

## Claims

1. Moulding device (1) for producing a moulded module (30),
wherein the moulding device (1) has a tool part (2) and a further tool part (3) which together enclose a cavity (6, 7),
and one tool part (2) has at least one separating wall (4) which is arranged and configured to divide the cavity (6, 7, 21, 22) into at least two or only two partial chambers (6, 7), specifically a low-pressure partial chamber (6, 21) and a high-pressure partial chamber (7, 22), and the tool part (2) has at least two injection channels (8, 9, 24, 25), and of which a low-pressure injection channel (8) opens out into the low-pressure cavity (6) and, at least over a longitudinal portion (10), has a smaller cross section (12) than a high-pressure injection channel (9) which opens out into the high-pressure partial chamber (7), and wherein the low-pressure injection channel (8) is configured to be plugged in a pressure-tight manner, in particular during a predetermined time interval (38), by way of hardening moulding material (20'), while the high-pressure injection channel (9) is configured to direct a moulding pressure (19) into the cavity (7) for a longer time interval (40) than the low-pressure injection channel (8).

2. Moulding device (1) according to Claim 1,
**characterized in that**
the low-pressure injection channel (8) has a longitudinal portion (10) which is narrowed, in particular in comparison with the adjacent channel portion, and whose cross-sectional diameter (12) is less than half the cross-sectional diameter (13) of the high-pressure injection channel (9) or whose cross-sectional area is less than half the cross-sectional area of the high-pressure injection channel (9).

3. Moulding device (1) according to Claim 1 or 2,
**characterized in that**
the separating wall (4) is configured and arranged to bear, in particular resiliently, on a circuit carrier (14) which is enclosed by the tool parts (2, 3), and to divide the cavity (6, 7) thus formed between the circuit carrier (14) and the tool part (2) into the low-pressure cavity (6) and the high-pressure cavity (7).

4. Moulding device (1) according to one of the preceding claims, **characterized in that**
the tool part (2) has a pressing device (27) which is connected to the tool part (2) or is integrally formed on the tool part (2) and which is configured to press in particular viscous moulding material (20) into the injection channels (8, 9).

5. Moulding device (1) according to one of the preceding claims, **characterized in that**
the moulding device (1) has a pressure sensor (42) which is configured to detect a moulding pressure in the low-pressure injection channel (8).

6. Moulding device (1) according to Claim 5,
**characterized in that**
the pressure sensor (42) is arranged in the region of the low-pressure cavity (6).

7. Moulding device (1) according to one of the preceding claims, **characterized in that**
the moulding device (1) has a material-flow-detecting device (300), which is configured to detect a moulding-material flow flowing in the low-pressure injection channel (8) and to generate a moulding-material-flow signal representing the moulding-material flow, and the moulding device (1) is configured to control the moulding pressure or the moulding-material injection volume according to the moulding-material-flow signal.

8. Moulding device (1) according to one of the preceding claims, **characterized in that**
the moulding device (1) is configured to increase the moulding pressure after the predetermined time interval (38) has elapsed.

9. Moulded module (30) comprising a circuit carrier (14), components (17) insensitive to pressure for moulding at a moulding pressure of 50 to 200 bar, and at least one component (15, 16) sensitive to pressure for moulding at a moulding pressure of 50 bar or above, in particular electrolytic capacitor, quartz oscillator or sensor, and in particular produced by means of a moulding device (1) according to one of the preceding claims,
**characterized in that**
the moulded module (30) has two mutually different moulded bodies (31, 32), specifically a high-pressure moulded body (32) and a low-pressure moulded body (31), wherein pressure-insensitive components (17) are each embedded in the high-pressure moulded body (32) and the pressure-sensitive components (15, 16) are each embedded in the low-pressure moulded body (31), wherein the low-pressure moulded body (31) is produced at a smaller process pressure, specifically at a moulding pressure of less than or equal to 20 bar, than the high-pressure moulded body (32), which is produced at a moulding pressure between 50 and 200 bar.

10. Method for producing a moulded module (30) by means of a plastics pressure-casting process, for example by means of transfer moulding or by means of direct-injection moulding,
wherein a circuit carrier (14) with electronic components (14, 15, 16, 17) is introduced into a cavity (6, 7) of a moulding tool (2, 3) of a moulding device (1), and the cavity (6, 7) is divided into a low-pressure partial chamber (6) and a high-pressure partial chamber (7) by the moulding tool (2, 3) by means of a separating wall (4) which is connected to said moulding tool,
and the low-pressure partial chamber (6) is filled with moulding material (20) via a low-pressure injection channel (8) which is formed in the moulding tool (2, 3) and which opens out into the low-pressure partial chamber (6),
and the high-pressure partial chamber (7) is filled with moulding material (20) via a high-pressure injection channel (9) which is formed in the moulding tool (2, 3) and which opens out into the high-pressure partial chamber (7),
and the moulding pressure is increased up to a predetermined low-pressure value, in particular 20 bar, and, after a predetermined time interval (38) until the low-pressure injection channel (8) is plugged, the moulding pressure is further increased up to a high-pressure value, in particular 100 bar.

## Revendications

1. Dispositif de moulage (1) pour produire un module de moulage (30),
le dispositif de moulage (1) présentant une partie d'outil (2) et une autre partie d'outil (3) qui, conjointement, entourent un espace creux (6, 7),
et une partie d'outil (2) présente au moins une paroi de séparation (4) qui est agencée et conçue pour diviser l'espace creux (6, 7, 21, 22) en au moins deux, ou en seulement deux, parties d'espace (6, 7), à savoir une partie d'espace à basse pression (6, 21) et une partie d'espace à haute pression (7, 22), et la partie d'outil (2) présente au moins deux canaux d'alimentation (8, 9, 24, 25), et parmi lesquels un canal d'alimentation à basse pression (8) débouche dans l'espace creux à basse pression (6) et présente, au moins sur une partie longitudinale (10), une section transversale (12) plus petite qu'un canal d'alimentation à haute pression (9) débouchant dans la partie d'espace à haute pression (7), et le canal d'alimentation à basse pression (8) étant conçu de façon à être obturé, en particulier pendant un intervalle de temps prédéterminé (38), de manière résistante à la pression par une masse à mouler (20') en solidification, tandis que le canal d'alimentation à haute pression (9) est conçu pour conduire une pression de moulage (19) dans l'espace creux (7) pendant un intervalle de temps (40) plus long que le canal d'alimentation à basse pression (8).

2. Dispositif de moulage (1) selon la revendication 1,
**caractérisé en ce que**
le canal d'alimentation à basse pression (8) présente une partie longitudinale (10) rétrécie en particulier par rapport à la partie de canal voisine, dont le diamètre de la section transversale (12) est inférieur à la moitié du diamètre de la section transversale (13) du canal d'alimentation à haute pression (9) ou dont la surface de la section transversale est inférieure à la moitié de la surface de la section transversale du canal d'alimentation à haute pression (9).

3. Dispositif de moulage (1) selon la revendication 1 ou la revendication 2, **caractérisé en ce que**
la paroi de séparation (4) est conçue et agencée de façon à être placée, notamment de manière élastique, sur un support de circuit (14) entouré par les parties d'outil (2, 3) et pour diviser l'espace creux (6, 7) ainsi formé entre le support de circuit (14) et la partie d'outil (2) en l'espace creux à basse pression (6) et l'espace creux à haute pression (7).

4. Dispositif de moulage (1) selon l'une des revendications précédentes, **caractérisé en ce que**
la partie d'outil (2) présente un dispositif de pressage (27) relié à la partie d'outil (2) ou formé sur la partie d'outil (2), lequel est conçu pour presser en particulier une masse à mouler visqueuse (20) dans les canaux d'alimentation (8, 9).

5. Dispositif de moulage (1) selon l'une des revendications précédentes, **caractérisé en ce que**
le dispositif de moulage (1) comporte un capteur de pression (42) qui est configuré pour détecter une pression de moulage dans le canal d'alimentation à basse pression (8).

6. Dispositif de moulage (1) selon la revendication 5,
**caractérisé en ce que**
le capteur de pression (42) est agencé dans la zone de l'espace creux à basse pression (6).

7. Dispositif de moulage (1) selon l'une des revendications précédentes, **caractérisé en ce que**
le dispositif de moulage (1) comporte un dispositif de détection de débit massique (300) qui est conçu pour détecter un débit massique de moulage s'écoulant dans le canal d'alimentation à basse pression (8), et pour générer un signal de débit massique de moulage représentatif du débit massique de moulage, et le dispositif de moulage (1) est conçu pour commander la pression de moulage ou le volume d'alimentation de moulage en fonction du signal de débit massique de moulage.

8. Dispositif de moulage (1) selon l'une des revendications précédentes, **caractérisé en ce que**
le dispositif de moulage (1) est conçu pour augmenter la pression de moulage après l'écoulement de l'intervalle de temps prédéterminé (38).

9. Module de moulage (30), comprenant un support de circuit (14), des composants (17) insensibles à la pression pour le moulage avec une pression de moulage de 50 à 200 bars et au moins un composant (15, 16) sensible à la pression pour le moulage avec une pression de moulage à partir de 50 bars, en particulier un condensateur électrolytique, un quartz oscillant ou un capteur, et en particulier produit au moyen d'un dispositif de moulage (1) selon l'une des revendications précédentes,
**caractérisé en ce que**
le module de moulage (30) présente deux corps de moule (31, 32) différents l'un de l'autre, à savoir un corps de moule à haute pression (32) et un corps de moule à basse pression (31), des composants insensibles à la pression (17) étant respectivement noyés dans le corps de moule à haute pression (32) et les composants sensibles à la pression (15, 16) étant chacun intégrés dans le corps de moule à basse pression (31),
le corps de moule à basse pression (31) étant fabriqué avec une pression de processus plus faible, à savoir avec une pression de moule inférieure ou égale à 20 bars, que le corps de moule à haute pression (32), qui est fabriqué avec une pression de moule comprise entre 50 et 200 bars.

10. Procédé de fabrication d'un module de moulage (30) au moyen d'un procédé de moulage sous pression de matière plastique, par exemple au moyen d'un moulage par transfert ou d'un moulage par injection directe,
dans lequel un support de circuit (14) avec des composants électroniques (14, 15, 16, 17) est introduit dans un espace creux (6, 7) d'un outil de moulage (2, 3) d'un dispositif de moulage (1) et l'espace creux (6, 7) de l'outil de moulage (2, 3) est divisé au moyen d'une paroi de séparation (4) reliée à celui-ci, en une partie d'espace à basse pression (6) et une partie d'espace à haute pression (7),
et la partie d'espace à basse pression (6) est remplie d'une masse à mouler (20) par un canal d'alimentation à basse pression (8) formé dans l'outil de moulage (2, 3) et débouchant dans la partie d'espace à basse pression (6), et la partie d'espace à haute pression (7) est remplie d'une masse à mouler (20) via un canal d'alimentation à haute pression (9) formé dans l'outil de moulage (2, 3) et débouchant dans la partie d'espace à haute pression (7), et la pression du moule est augmentée jusqu'à une valeur de basse pression prédéterminée, en particulier 20 bars, et, après un intervalle de temps prédéterminé (38), jusqu'à l'obstruction du canal d'alimentation à basse pression (8), la pression du moule étant encore augmentée jusqu'à une valeur haute pression, en particulier 100 bars.
